# EUROPEAN PATENT APPLICATION

(11) **EP 4 105 981 A1**
(43) Date of publication of application: **21.12.2022**
(21) Application number: 22174054.1
(22) Date of filing: 18.05.2022
(51) Int. Cl.: H01L 21/84, H01L 27/12, H01L 27/06, H01L 21/20

(54) **LAYER TRANSFER ON NON-SEMICONDUCTOR SUPPORT STRUCTURES**

(30) Priority: 17.06.2021 US 202117350074
(71) Applicant: INTEL Corporation, Santa Clara, CA 95054 (US)
(72) Inventor: SHARMA, Abhishek Anil, Portland, 97229 (US); GOMES, Wilfred, Portland, 97229 (US); KAMGAING, Telesphor, Chandler, 85249 (US)
(74) Representative: 2SPL Patentanwälte PartG mbB

(57) **Abstract**

Embodiments of the present disclosure relate to methods of fabricating IC devices using layer transfer and resulting IC devices, assemblies, and systems. An example method includes fabricating a device layer over a semiconductor support structure, the device layer comprising a plurality of frontend devices; attaching the semiconductor support structure with the device layer to a carrier substrate so that the device layer is closer to the carrier substrate than the semiconductor support structure; removing at least a portion of the semiconductor support structure to expose the device layer; and bonding a support structure of a non-semiconductor material having a dielectric constant that is smaller than a dielectric constant of silicon (e.g., a glass wafer) to the exposed frontend layer. The carrier substrate may then be removed.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a block illustration of an integrated circuit (IC) device fabricated using layer transfer on a non-semiconductor support structure, according to some embodiments of the present disclosure.
FIGS. 2A-2B provide schematic illustrations of cross-sectional side views of an example IC device before and after layer transfer on a non-semiconductor support structure, according to some embodiments of the present disclosure.
FIGS. 3A-3B provide schematic illustrations of cross-sectional side views of another example IC device before and after layer transfer on a non-semiconductor support structure, according to some embodiments of the present disclosure.
FIGS. 4A-4D illustrate processes of an example method of fabricating an IC device using layer transfer on a non-semiconductor support structure, according to some embodiments of the present disclosure.
FIGS. 5A-5B provide schematic illustrations of cross-sectional side views of microelectronic assemblies with a front-to-front (f2f) bonding of two IC devices fabricated using layer transfer on a non-semiconductor support structure, according to some embodiments of the present disclosure.
FIGS. 6A-6B provide schematic illustrations of cross-sectional side views of microelectronic assemblies with a front-to-back (f2b) bonding of two IC devices fabricated using layer transfer on a non-semiconductor support structure, according to some embodiments of the present disclosure.
FIGS. 7A-7B provide schematic illustrations of cross-sectional side views of microelectronic assemblies with a back-to-back (b2b) bonding of two IC devices fabricated using layer transfer on a non-semiconductor support structure, according to some embodiments of the present disclosure.
FIG. 8 is a cross-sectional side view of an IC package that may include an IC device fabricated using layer transfer on a non-semiconductor support structure in accordance with any of the embodiments disclosed herein.
FIG. 9 is a cross-sectional side view of an IC device assembly that may include an IC device fabricated using layer transfer on a non-semiconductor support structure in accordance with any of the embodiments disclosed herein.
FIG. 10 is a block diagram of an example computing device that may include an IC device fabricated using layer transfer on a non-semiconductor support structure in accordance with any of the embodiments disclosed herein.

### Detailed Description

### Overview

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

Embodiments of the present disclosure relate to methods of fabricating IC devices using layer transfer and resulting IC devices, assemblies, and systems. An example method includes fabricating a device layer over a semiconductor support structure, the device layer comprising a plurality of frontend devices; attaching the semiconductor support structure with the device layer to a carrier substrate so that the device layer is closer to the carrier substrate than the semiconductor support structure; performing a back-side reveal by removing at least a portion of the semiconductor support structure to expose the device layer; and bonding a support structure of a non-semiconductor material having a dielectric constant that is smaller than a dielectric constant of silicon (e.g., a glass wafer) to the exposed frontend layer. The carrier substrate may then be removed. In this manner, a device layer that includes frontend devices, e.g., transistors, having portions (e.g., channel portions) of a semiconductor material of the semiconductor support structure may be transferred onto a non-semiconductor support structure, such as glass (e.g., a glass substrate or a glass wafer). An example resulting IC device includes a support structure of a non-semiconductor material having a dielectric constant that is smaller than a dielectric constant of silicon (e.g., lower than about 11); a device layer, wherein a portion of the device layer includes a semiconductor material; and a bonding interface between the support structure and the device layer. Embodiments of the present disclosure are based on recognition that using a support structure of a non-semiconductor material having a dielectric constant that is smaller than a dielectric constant of silicon at the back side of an IC device may advantageously reduce parasitic effects of various devices (e.g., frontend transistors) of the IC device, e.g., compared to using a silicon-based (Si) support structure at the back. In some embodiments, such a non-semiconductor support structure may be a glass support structure, and may include any type of glass materials, since glass has dielectric constants in a range between about 5 and 10.5. However, in other embodiments, such a non-semiconductor support structure may include materials other than glass, e.g., mica, as long as those materials have sufficiently low dielectric constants. Arranging a non-semiconductor support structure with a dielectric constant lower than that of Si at the back of an IC device may advantageously decrease various parasitic effects associated with the IC device, since such parasitic effects are typically proportional to the dielectric constant of the surrounding medium.

While some descriptions provided herein may refer to transistors being top-gated transistors, embodiments of the present disclosure are not limited to only this design and include transistors of various other architectures, or a mixture of different architectures. For example, in various embodiments, various transistors described herein may include bottom-gated transistors, top-gated transistors, FinFETs, nanowire transistors, planar transistors, etc., all of which being within the scope of the present disclosure. Furthermore, although descriptions of the present disclosure may refer to logic devices or memory cells provided in a given layer, each layer of the IC devices described herein may also include other types of devices besides logic or memory devices described herein.

Furthermore, in the following detailed description, various aspects of the illustrative implementations will be described using terms commonly employed by those skilled in the art to convey the substance of their work to others skilled in the art.

For example, a term "interconnect" may be used to describe any element formed of an electrically conductive material for providing electrical connectivity to one or more components associated with an IC or/and between various such components. In general, the "interconnect" may refer to both conductive lines/wires (also sometimes referred to as "lines" or "metal lines" or "trenches") and conductive vias (also sometimes referred to as "vias" or "metal vias"). In general, a term "conductive line" may be used to describe an electrically conductive element isolated by a dielectric material typically comprising an interlayer low-k dielectric that is provided within the plane of an IC chip. Such conductive lines are typically arranged in several levels, or several layers, of metallization stacks. On the other hand, the term "conductive via" may be used to describe an electrically conductive element that interconnects two or more conductive lines of different levels of a metallization stack. To that end, a via may be provided substantially perpendicularly to the plane of an IC chip or a support structure over which an IC structure is provided and may interconnect two conductive lines in adjacent levels or two conductive lines in not adjacent levels. A term "metallization stack" may be used to refer to a stack of one or more interconnects for providing connectivity to different circuit components of an IC chip.

In another example, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple sub-elements. For example, "an electrically conductive material" may include one or more electrically conductive materials. If used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function. The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

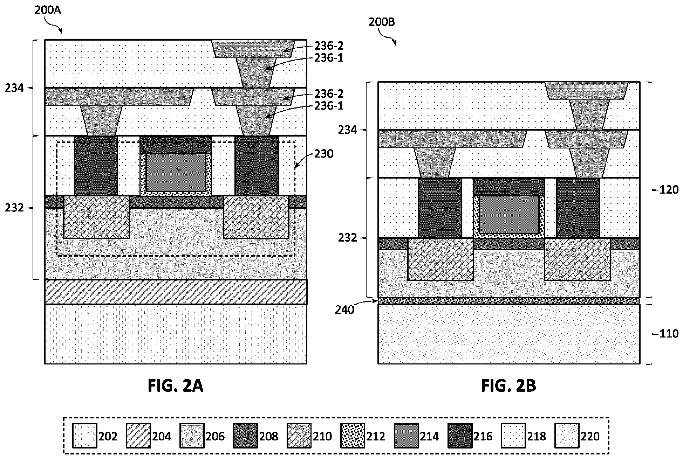

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 2A-2B, such a collection may be referred to herein without the letters, e.g., as "FIG. 2."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Various devices and assemblies illustrated in the present drawings do not represent an exhaustive set of IC devices fabricated using layer transfer on a non-semiconductor support structure as described herein, but merely provide examples of such devices. In particular, the number and positions of various elements shown in the present drawings is purely illustrative and, in various other embodiments, other numbers of these elements, provided in other locations relative to one another may be used in accordance with the general architecture considerations described herein. Further, the present drawings are intended to show relative arrangements of the elements therein, and the devices and assemblies of these figures may include other elements that are not specifically illustrated (e.g., various interfacial layers). Similarly, although particular arrangements of materials are discussed with reference to the present drawings, intermediate materials may be included in the IC devices and assemblies of these figures. Still further, although some elements of the various cross-sectional views are illustrated in the present drawings as being planar rectangles or formed of rectangular solids, this is simply for ease of illustration, and embodiments of these assemblies may be curved, rounded, or otherwise irregularly shaped as dictated by, and sometimes inevitable due to, the manufacturing processes used to fabricate semiconductor device assemblies. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of the IC devices fabricated using layer transfer on a non-semiconductor support structure as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC assemblies with IC devices fabricated using layer transfer on a non-semiconductor support structure as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

### Example IC devices and methods

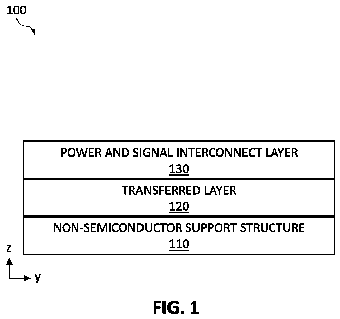

FIG. 1 provides a schematic block illustration of an example IC device 100 fabricated using layer transfer on a non-semiconductor support structure, according to some embodiments of the present disclosure. As shown in FIG. 1, in general, the IC device 100 may include a non-semiconductor support structure 110, a transferred layer 120, and, optionally, a power and signal interconnect layer 130.

Implementations of the present disclosure may be formed or carried out on the non-semiconductor support structure 110, which may be, e.g., a glass substrate, a glass die, a glass wafer or a glass chip. In some embodiments, the non-semiconductor support structure 110 may include a glass material. Examples of glass materials include silicon oxide materials, possibly doped with elements and compounds such as boron, carbon, aluminum, hafnium oxide, e.g., in doping concentrations of between about 0.01% and 10%. In other embodiments, the non-semiconductor support structure 110 may include other solid materials having a dielectric constant lower than that of Si, e.g., lower than about 10.5. In some embodiments, the non-semiconductor support structure 110 may include mica. A thickness of the non-semiconductor support structure 110 may be of any value for the non-semiconductor support structure 110 to provide mechanical stability for the IC device 100 and, possibly, to support inclusion of various devices for further reducing the parasitic effects in the IC device. In some embodiments, the non-semiconductor support structure 110 may have a thickness between about 0.2 micrometer (micron) and 1000 micron, e.g., between about 0.5 and 5 micron, or between about 1 and 3 micron. Although a few examples of materials from which the non-semiconductor support structure 110 may be formed are described here, any material with sufficiently low dielectric constant that may serve as a foundation upon which an IC device fabricated using layer transfer as described herein may be provided falls within the spirit and scope of the present disclosure.

The transferred layer 120 may include at least a device layer, where at least a portion of the device layer includes a semiconductor material and further includes one or more frontend devices fabricated based on the semiconductor material. For example, the device layer may be a front end of line (FEOL) layer with the frontend devices including transistors fabricated on a semiconductor substrate so that transistor channels include portions of the semiconductor material of the semiconductor substrate. In various embodiments, such transistors may be planar transistors or non-planar transistors (e.g., FinFETs, nanoribbon transistors, nanowire transistors, etc.). In some embodiments, the transferred layer 120 may further include a backend layer comprising one or more interconnects and/or backend devices, which may be coupled to one or more of the frontend devices. For example, the backend layer may be a back end of line (BEOL) layer with the backend devices including backend transistors, such as thin-film transistors (TFTs). For example, the device layer of the transferred layer 120 may be a compute logic layer in that it may include various logic layers, circuits, and devices (e.g., logic transistors) to drive and control a logic IC. For example, the logic devices of the compute logic layer of the transferred layer 120 may form a memory peripheral circuit to control (e.g., access (read/write), store, refresh) the memory cells of the memory array, where the memory array may be implemented in the backend layer using TFTs.

In some embodiments, the device layer of the transferred layer 120 may be provided in a FEOL and in one or more lowest BEOL layers (i.e., in one or more BEOL layers which are closest to the non-semiconductor support structure 110), while the backend layer of the transferred layer 120 may be seen as provided in respective BEOL layers. Various BEOL layers may be, or include, metal layers. Various metal layers of the BEOL may be used to interconnect the various inputs and outputs of the logic devices in the device layer of the transferred layer 120 and/or of the backend devices in the backend layer of the transferred layer 120. Generally speaking, each of the metal layers of the BEOL may include a via portion and a trench/interconnect portion. The trench portion of a metal layer is configured for transferring signals and power along electrically conductive (e.g., metal) lines (also sometimes referred to as "trenches") extending in the x-y plane (e.g., in the x or y directions), while the via portion of a metal layer is configured for transferring signals and power through electrically conductive vias extending in the z-direction, e.g., to any of the adjacent metal layers above or below. Accordingly, vias connect metal structures (e.g., metal lines or vias) from one metal layer to metal structures of an adjacent metal layer. While referred to as "metal" layers, various layers of the BEOL may include only certain patterns of conductive metals, e.g., copper (Cu), aluminum (Al), Tungsten (W), or Cobalt (Co), or metal alloys, or more generally, patterns of an electrically conductive material, formed in an insulating medium such as an interlayer dielectric (ILD). The insulating medium may include any suitable ILD materials such as silicon oxide, carbon-doped silicon oxide, silicon carbide, silicon nitride, aluminum oxide, and/or silicon oxynitride.

The power and signal interconnect layer 130 may include one or more electrical interconnects configured to provide power and/or signals to/from various components of the IC device 100 (e.g., to the devices in the device layer of the transferred layer 120 and/or to the devices in the backend layer of the transferred layer 120).

The illustration of FIG. 1 is intended to provide a general orientation and arrangement of various layers with respect to one another, and, unless specified otherwise in the present disclosure, includes embodiments of the IC device 100 where portions of elements described with respect to one of the layers shown in FIG. 1 may extend into one or more, or be present in, other layers. For example, power and signal interconnects for the various components of the IC device 100 may be present in any of the layers shown in FIG. 1, although not specifically illustrated in FIG. 1.

FIGS. 2A-2B provide schematic illustrations of cross-sectional side views of an example IC device 200 before and after layer transfer on a non-semiconductor support structure, according to some embodiments of the present disclosure. FIG. 2A illustrates an IC device 200A before the layer transfer and FIG. 2B illustrates an IC device 200B after the layer transfer.

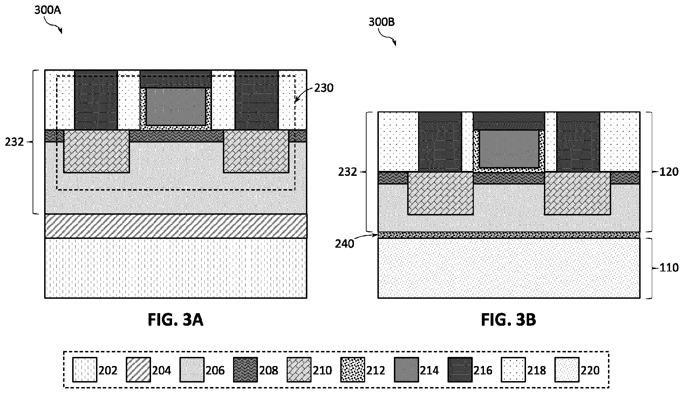

A number of elements referred to in the description of FIGS. 2A-2B, as well as in the descriptions of FIGS. 3-7, with reference numerals are illustrated in these figures with different patterns, with a legend showing the correspondence between the reference numerals and patterns being provided at the bottom of each drawing page containing these drawings. For example, the legend illustrates that FIGS. 2A-2B use different patterns to show a semiconductor support structure 202, a non-semiconductor support structure 220, etc.

As shown in FIG. 2A, before the layer transfer, the IC device 200A may include a semiconductor support structure 202 and a layer of a semiconductor material 206 based on which one or more active devices of the device layer will be fabricated. In some embodiments, the semiconductor material 206 may be a part of the semiconductor support structure 202. In other embodiments, one or more intermediate layers 204 may be present between the semiconductor support structure 202 and the semiconductor material 206.

In some embodiments, layer transfer method as described herein may be used to transfer layers of III-N semiconductor materials onto non-semiconductor support structures. In such embodiments, the semiconductor material 206 may be a III-N semiconductor material and the IC device 200A may further include a polarization material 208. In other embodiments, the semiconductor material 206 may include a semiconductor material other than a III-N semiconductor material and the polarization material 208 may be absent.

In various embodiments, the channel material of the frontend/FEOL devices of the transferred layer 120 may include, or may be formed upon, the semiconductor material 206. This is illustrated in FIG. 2A with a transistor 230 formed by having a first and a second source/drain (S/D) regions 210, a gate stack of a gate metal 214 and, optionally, a gate dielectric 212, and S/D electrodes 216 to the S/D regions 210. The semiconductor material 206 and any devices built thereon, e.g., the transistor 230, may form a device/FEOL layer 232. As further shown in FIG. 2A, the IC device 200A may further include a backend layer 234 that may include one or more interconnects, shown for the example of FIG. 2A as one or more vias 236-1 and one or more lines 236-2. FIG. 2A also illustrates an insulator material 218 that may enclose portions of the devices and/or interconnects of the device layer 232 and the backend layer 234.

FIG. 2B illustrates that the device layer 232 and the backend layer 234 may be transferred onto a non-semiconductor support structure 220 (which is an example of the non-semiconductor support structure 110 of FIG. 1), thus together forming a transferred layer 120 as shown in FIG. 1. FIG. 2B further illustrates a bonding interface 240 that results from bonding the device layer 232 to the non-semiconductor substrate 220.

Now various example materials of the IC devices 200A, 200B will be described.

The semiconductor support structure 202 may be a semiconductor substrate composed of semiconductor material systems including, for example, N-type or P-type materials systems. In one implementation, the semiconductor support structure 202 may be a crystalline substrate formed using a bulk silicon. In some embodiments, the intermediate layer 204 may include an insulator, and the semiconductor material 206 may include silicon (e.g., epitaxially grown silicon, e.g., crystalline silicon) and, together, the semiconductor support structure 202, the intermediate layer 204, and the semiconductor material 206 may form a silicon-on-insulator (SOI) substructure. In other implementations, the semiconductor support structure 202 may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the semiconductor support structure 202 may be non-crystalline. In some embodiments, the semiconductor support structure 202 may be a printed circuit board (PCB) substrate. Although a few examples of materials from which the semiconductor support structure 202 may be formed are described here, any material that may serve as a foundation upon which IC devices fabricated using layer transfer on a non-semiconductor support structure as described herein may be built falls within the spirit and scope of the present disclosure.

In various embodiments, the semiconductor material 206 may be composed of semiconductor material systems including, for example, N-type or P-type materials systems. In some embodiments, the semiconductor material 206 may be formed of a monocrystalline semiconductor. In some embodiments, the semiconductor material 206 may have a thickness between about 5 and 10000 nanometers, including all values and ranges therein, e.g., between about 10 and 500 nanometers, between about 10 and 200 nanometers, or about between 10 and 100 nanometers.

In some embodiments, the semiconductor material 206 may be an upper layer of the semiconductor support structure 202 (e.g., the semiconductor material 206 may be silicon, e.g., an upper layer of silicon of a silicon substrate) and the intermediate layer 204 may be absent. Thus, in some implementations, the semiconductor material 206 may be viewed as a part of the support structure over which it is provided, or as a part of the crystalline semiconductor upper part of such support structure. In some embodiments, the intermediate layer 204 may be included as an insulating layer, such as an oxide isolation layer, and the semiconductor material 206 may be provided over the oxide isolation layer, in a silicon-on-insulator (SOI) manner.

In some embodiments, the semiconductor material 206 may be/include an intrinsic IV or III-V semiconductor material or alloy, not intentionally doped with any electrically active impurity. In alternate embodiments, nominal impurity dopant levels may be present within the semiconductor material 206, for example to set a threshold voltage Vt, or to provide HALO pocket implants, etc. In such impurity-doped embodiments however, impurity dopant level within the semiconductor material 206 may be relatively low, for example below about 10¹⁵ cm⁻³, and advantageously below 10¹³ cm⁻³.

In some embodiments, the semiconductor material 206 may be formed of a compound semiconductor with a first sub-lattice of at least one element from group III of the periodic table (e.g., Al, Ga, In), and a second sub-lattice of at least one element of group V of the periodic table (e.g., P, As, Sb). In some embodiments, the semiconductor material 206 may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

For exemplary P-type transistor embodiments, the semiconductor material 206 may advantageously be a group IV material having a high hole mobility, such as, but not limited to, Ge or a Ge-rich SiGe alloy. For some exemplary embodiments, the semiconductor material 206 may have a Ge content between 0.6 and 0.9, and advantageously is at least 0.7.

For exemplary N-type transistor embodiments, the semiconductor material 206 may advantageously be an III-V material having a high electron mobility, such as, but not limited to InGaAs, InP, InSb, and InAs. For some such embodiments, the semiconductor material 206 may be a ternary III-V alloy, such as InGaAs or GaAsSb. For some InₓGa₁₋ₓAs fin embodiments, In content in the semiconductor material 206 may be between 0.6 and 0.9, and advantageously at least 0.7 (e.g., In_{0.7}Ga_{0.3}As).

In some embodiments, the semiconductor material 206 may be a thin-film material, in which embodiments the transistor 230 could be a TFT. A TFT is a special kind of a field-effect transistor (FET), made by depositing a thin film of an active semiconductor material, as well as a dielectric layer and metallic contacts, over a support structure that may be a non-conducting (and non-semiconducting) support structure. During operation of a TFT, at least a portion of the active semiconductor material forms a channel of the TFT, and, therefore, the thin film of such active semiconductor material is referred to herein as a "TFT channel material." This is different from conventional, non-TFT, transistors where the active semiconductor channel material is typically a part of a semiconductor substrate, e.g., a part of a silicon wafer. In various such embodiments, the semiconductor material 206 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the semiconductor material 206 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc.

In some embodiments, layer transfer method as described herein may be used to transfer layers of III-N semiconductor materials onto non-semiconductor support structures. In such embodiments, the semiconductor material 206 may be a III-N semiconductor material. In some embodiments, the III-N semiconductor material 206 may be formed of a compound semiconductor with a first sub-lattice of at least one element from group III of the periodic table (e.g., Al, Ga, In), and a second sub-lattice of nitrogen (N). In some embodiments, the III-N semiconductor material 206 may be a binary, ternary, or quaternary III-N compound semiconductor that is an alloy of two, three, or even four elements from group III of the periodic table (e.g., boron, aluminum, indium, gallium) and nitrogen.

In general, the III-N semiconductor material 206 may be composed of various III-N semiconductor material systems including, for example, N-type or P-type III-N materials systems, depending on whether the III-N semiconductor material 206 is an N-type or a P-type transistor. For some N-type transistor embodiments, the III-N semiconductor material 206 may advantageously be an III-N material having a high electron mobility, such as, but not limited to, GaN. In some embodiments, the III-N semiconductor material 206 may be a ternary III-N alloy, such as InGaN, or a quaternary III-N alloy, such as AllnGaN, in any suitable stoichiometry.

Turning now to the polarization material 208 for the embodiments when the semiconductor material 206 is a III-N semiconductor material 206 and the transistor 230 is a III-N transistor 230, in general, the polarization material 208 may be a layer of a charge-inducing film of a material having larger spontaneous and/or piezoelectric polarization than that of the bulk of the III-N layer material immediately below it (e.g., the III-N semiconductor material 206), creating a heterojunction (i.e., an interface that occurs between two layers or regions of semiconductors having unequal band gaps) with the III-N semiconductor material 206, and leading to formation of 2DEG at or near (e.g., immediately below) that interface, during operation of the III-N transistor 230. As described above, a 2DEG layer may be formed during operation of an III-N transistor in a layer of an III-N semiconductor material immediately below a suitable polarization layer. In various embodiments, the polarization material 208 may include materials such as AIN, InAIN, AIGaN, or AlₓIn_{y}Ga_{1-x-y}N, and may have a thickness between about 1 and 50 nanometers, including all values and ranges therein, e.g., between about 5 and 15 nanometers or between about 10 and 30 nanometers.

As also shown in FIG. 2, the transistor 230 may include two S/D regions 210, where one of the S/D regions 210 is a source region and another one is a drain region, where the "source" and the "drain" designations may be interchangeable. As is well-known, in a transistor, S/D regions (also sometimes interchangeably referred to as "diffusion regions") are regions that can supply charge carriers for the transistor channel of the transistor (e.g., the transistor 230). In some embodiments, the S/D regions 210 may include highly doped semiconductor materials, such as highly doped InGaN. Often, the S/D regions may be highly doped, e.g., with dopant concentrations of at least above 1·10²¹ cm⁻³, in order to advantageously form Ohmic contacts with the respective S/D electrodes/contacts of the transistor 230 (e.g., electrodes 216 shown in FIG. 2), although these regions may also have lower dopant concentrations in some implementations. Regardless of the exact doping levels, the S/D regions 210 are the regions having dopant concentration higher than in other regions between the source region (e.g., the S/D region 210 shown on the left side in FIG. 2A) and the drain region (e.g., the S/D region 210 shown on the right side in FIG. 2A), i.e., higher than the semiconductor material 206. For that reason, sometimes the S/D regions are referred to as highly doped (HD) S/D regions. In further embodiments, one or more layers of metal and/or metal alloys may be used to form the S/D regions 210.

The electrically conductive material of the S/D electrodes 216 may include any suitable electrically conductive material, alloy, or a stack of multiple electrically conductive materials. In some embodiments, the electrically conductive material of the S/D electrodes 216 may include one or more metals or metal alloys, with metals such as copper, ruthenium, palladium, platinum, cobalt, nickel, hafnium, zirconium, titanium, tantalum, and aluminum, tantalum nitride, titanium nitride, tungsten, doped silicon, doped germanium, or alloys and mixtures of these. In some embodiments, the electrically conductive material of the S/D electrodes 216 may include one or more electrically conductive alloys, oxides, or carbides of one or more metals. In some embodiments, the electrically conductive material of the S/D electrodes 216 may include a doped semiconductor, such as silicon or another semiconductor doped with an N-type dopant or a P-type dopant. Metals may provide higher conductivity, while doped semiconductors may be easier to pattern during fabrication. In some embodiments, the S/D electrodes 216 may have a thickness between about 2 nanometers and 1000 nanometers, preferably between about 2 nanometers and 100 nanometers. FIG. 2 further illustrates that a similar electrically conductive material may also be used to form electrical contact to the gate electrode of the transistor 230 (i.e., in general, the electrically conductive material as described with reference to the S/D electrodes 216 may also be used to form electrical contacts to any of the transistor terminals of the transistor 230). In various embodiments, the exact material compositions of the electrically conductive material may be different when used to implement contacts to different electrodes of different transistors within the IC device 200.

FIG. 2A further illustrates a gate stack provided over the channel portion of the transistor 230 (i.e., provided over the channel portion of the semiconductor material 206). The gate stack may include a gate dielectric material 212, and a gate electrode material 214.

The gate dielectric material 212 may be a high-k dielectric material, e.g., a material including elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric material 212 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric material 212 during manufacture of the Transistor 230 to improve the quality of the gate dielectric material 212. A thickness of the gate dielectric material 212 may be between 0.5 nanometers and 10 nanometers, including all values and ranges therein, e.g., between 1 and 3 nanometers, or between 1 and 2 nanometers.

The gate electrode material 214 may include at least one P-type work function metal or N-type work function metal, depending on whether the transistor 230 is a PMOS transistor or an NMOS transistor (e.g., P-type work function metal may be used as the gate electrode material 214 when the transistor 230 is a PMOS transistor and N-type work function metal may be used as the gate electrode material 214 when the transistor 230 is an NMOS transistor, depending on the desired threshold voltage). For a PMOS transistor, metals that may be used for the gate electrode material 214 may include, but are not limited to, ruthenium, palladium, platinum, cobalt, nickel, titanium nitride, and conductive metal oxides (e.g., ruthenium oxide). For an NMOS transistor, metals that may be used for the gate electrode material 214 include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and nitrides of these metals (e.g., tantalum nitride, and tantalum aluminum nitride). In some embodiments, the gate electrode material 214 may include a stack of two or more metal layers, where one or more metal layers are work function metal layers and at least one metal layer is a fill metal layer.

Further layers may be included next to the gate electrode material 214 for other purposes, such as to act as a diffusion barrier layer or/and an adhesion layer, not specifically shown in FIG. 2. Furthermore, in some embodiments, the gate dielectric material 212 and the gate electrode material 214 may be surrounded by a gate spacer, not shown in FIG. 2, configured to provide separation between the gates of different transistors. Such a gate spacer may be made of a low-k dielectric material (i.e., a dielectric material that has a lower dielectric constant (k) than silicon dioxide which has a dielectric constant of 3.9). Examples of low-k materials that may be used as the dielectric gate spacer may include, but are not limited to, fluorine-doped silicon dioxide, carbon-doped silicon dioxide, spin-on organic polymeric dielectrics such as polyimide, polynorbornenes, benzocyclobutene, and polytetrafluoroethylene (PTFE), or spin-on silicon-based polymeric dielectric such as hydrogen silsesquioxane (HSQ) and methylsilsesquioxane (MSQ)). Other examples of low-k materials that may be used as the dielectric gate spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. In some embodiments, the insulator material 218 may include any of the materials described with reference to the gate spacer. In some embodiments, the insulator material 218 may include any of the ILD materials described herein.

In some embodiments, e.g., when the semiconductor material 206 is a III-N semiconductor material, the IC device 200A may, optionally, include a buffer material in the intermediate layer 204 between the semiconductor material 206 and the support structure 202. In some embodiments, the buffer material may be a layer of a semiconductor material that has a band gap larger than that of the III-N semiconductor material 206. Furthermore, a properly selected semiconductor for the buffer material may enable better epitaxy of the III-N semiconductor material 206 thereon, e.g., it may improve epitaxial growth of the III-N semiconductor material 206, for instance in terms of a bridge lattice constant or amount of defects. For example, a semiconductor that includes aluminum, gallium, and nitrogen (e.g., AIGaN) or a semiconductor that includes aluminum and nitrogen (e.g., AIN) may be used as the buffer material when the semiconductor material 206 is a semiconductor that includes gallium and nitrogen (e.g., GaN). Other examples of materials for the buffer material of the intermediate layer 204 may include materials typically used as ILD, described above, such as oxide isolation layers, e.g., silicon oxide, silicon nitride, aluminum oxide, and/or silicon oxynitride. In various embodiments, the intermediate layer 204 may have a thickness between about 100 and 5000 nanometers, including all values and ranges therein, e.g., between about 200 and 1000 nanometers, or between about 250 and 500 nanometers.

Although not specifically shown in FIG. 2, the IC device 200A may further include additional transistors similar to the transistor 230, described above.

FIG. 2B illustrates that the device layer 232 and the backend layer 234 of the IC device 200A of FIG. 2A may be transferred onto a non-semiconductor support structure 220 (which is an example of the non-semiconductor support structure 110 of FIG. 1), thus together forming a transferred layer 120 as shown in FIG. 1. FIG. 2B further illustrates a bonding interface 240 between the device layer 232 and the non-semiconductor substrate 220.

FIGS. 3A-3B provide schematic illustrations of cross-sectional side views of another example IC device 300 before and after layer transfer on a non-semiconductor support structure, according to some embodiments of the present disclosure. The IC device 300A, shown in FIG. 3A, is substantially the same as the IC device 200A, shown in FIG. 2A, except that it illustrates that the backend layer 234 may not be included in the transferred layer 120. Thus, correspondingly, the IC device 300B, shown in FIG. 3B, is substantially the same as the IC device 200B, shown in FIG. 2B, except that it does not include the backend layer 234. In other embodiments, the transferred layer 120 may include portions of, but not all of the elements shown in FIGS. 2A and 3A. For example, in some embodiments, layer transfer as described herein may be performed after the semiconductor material 206 is provided but before portions of the transistor 230 are fabricated, and the transistor 230 may be fabricated based on the semiconductor material 206 after the layer transfer. In another example, layer transfer as described herein may be performed after the semiconductor material 206 and the S/D regions 210 are provided but before other portions of the transistor 230 are fabricated, and other portions of the transistor 230 may be fabricated based on the semiconductor material 206 after the layer transfer.

The IC devices 200B and 300B are examples of the IC device 100. Although not specifically shown in the present drawings, the IC devices 200B and 300B may further include the power and signal interconnect layer 130 as described herein.

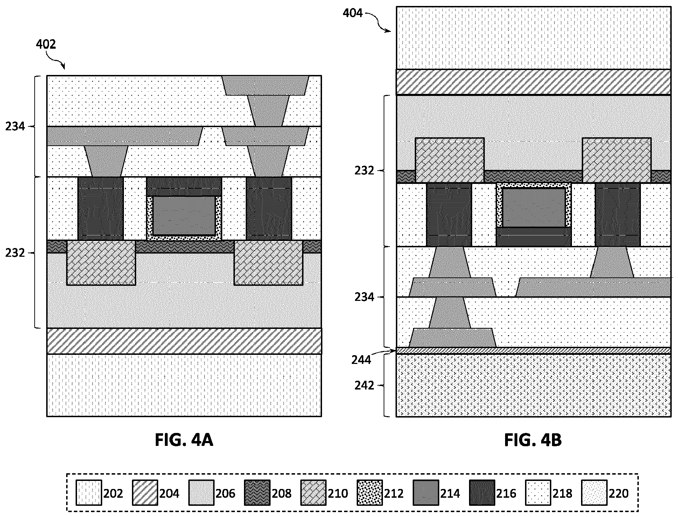

FIGS. 4A-4D illustrate processes of an example method of fabricating an IC device, e.g., any embodiments of the IC device 100, using layer transfer on a non-semiconductor support structure, according to some embodiments of the present disclosure. The example fabrication method shown in FIGS. 4A-4D may include other operations not specifically shown in FIGS. 4A-4D, such as various cleaning or planarization operations as known in the art. For example, in some embodiments, any layers of the IC devices shown in FIGS. 4A-4D may be cleaned prior to, after, or during any of the processes of the fabrication method described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the IC devices as described herein may be planarized prior to, after, or during any of the processes of the fabrication method described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

The fabrication method may begin with a process 402, shown in FIG. 4A, that includes fabricating any portions of the device layer 232 and, optionally, of the backend layer 234, as described above.

The fabrication method may then proceed with a process 404, shown in FIG. 4B, that includes flipping the IC device that was fabricated in the process 402 upside down and attaching it to a carrier substrate 242 so that further fabrication processes may be performed on the back side. FIG. 4B illustrates that a bonding material 244 may be used to attach the IC device that was fabricated in the process 402 to the carrier substrate 242. Because the IC device that was fabricated in the process 402 is flipped over prior to being attached to the carrier substrate 242, the device layer 232 is closer to the carrier substrate 242 than the semiconductor support structure 202, and the backend layer 234 is closer to the carrier substrate 242 than the device layer 232, as shown in FIG. 4B.

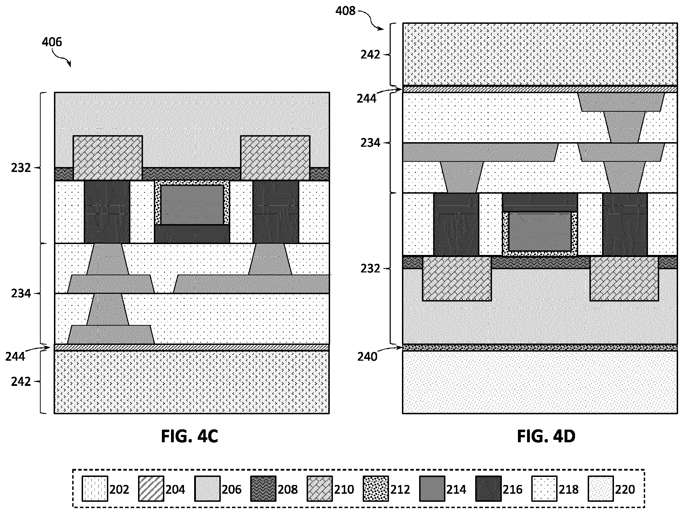

The fabrication method may then proceed with a process 406, shown in FIG. 4C, that includes grinding or polishing the semiconductor support structure 202 to reduce the thickness of or completely remove the semiconductor support structure 202. In some embodiments, grinding may be performed until the semiconductor material 206 is exposed, as shown in FIG. 4C. In other embodiments, grinding of the process 406 may be performed until the S/D regions 210 of the transistor(s) 230 of the device layer 232 are exposed (not shown in the present drawings). Still in other embodiments, a portion of the semiconductor support structure 202 may remain above the semiconductor material 206 (not shown in the present drawings), i.e., the S/D regions 210 of the transistor(s) 230 may not necessarily be exposed.

The fabrication method may conclude with a process 408, shown in FIG. 4D, that includes bringing the non-semiconductor support structure 220 (e.g., a glass support structure) in contact with the ground surface of the IC device formed in the process 406 and bonding these two structures together (i.e., the process 408 may include flipping the IC device formed in the process 406 over so that the semiconductor material 206 may be bonded to the non-semiconductor support structure 220). In some embodiments, bonding of the non-semiconductor support structure 220 to the back of the IC device formed in the process 406 may be performed using an insulator-insulator bonding, e.g., as oxide-oxide bonding, where the structures to be bonded are put together, possibly while applying a suitable pressure and heating up the assembly to a suitable temperature (e.g., to moderately high temperatures, e.g., between about 50 and 200 degrees Celsius) for a duration of time. In some embodiments, a bonding interface material may be applied to one or both faces of the structures to be bonded. In some embodiments, the bonding interface material may be an adhesive material that ensures attachment of the structures. In some embodiments, the bonding interface material may be an etch-stop material. In some embodiments, the bonding interface material may be both an etch-stop material and have suitable adhesive properties to ensure attachment of the structures to one another as described herein. In the embodiments when the bonding interface material is used, the bonding interface 240 may include such a bonding material. In some embodiments, no deliberately added adhesive bonding material may be used, in which case the bonding interface 240 represents a bonding interface resulting from the bonding of the respective structures to one another. Such a bonding interface may be recognizable as a seam or a thin layer in the IC devices described herein, using, e.g., selective area diffraction (SED), even when the specific materials of the insulators of the structures that are bonded together may be the same, in which case the bonding interface would still be noticeable as a seam or a thin layer in what otherwise appears as a bulk insulator (e.g., bulk oxide) layer.

Although not specifically shown in FIGS. 4A-4D, the fabrication method may further include removing the carrier substrate 242 and, possibly, also the bonding material 244. As a result of the fabrication method as shown in FIGS. 4A-4D, the semiconductor support structure 202 , or at least a substantial portion thereof, has been replaced with the non-semiconductor support structure 220 at the back of the IC device.

Although not specifically shown in the present drawings, in some embodiments, the non-semiconductor support structure 110/220 may further include various devices (e.g., thin-film resistors, thin-film capacitors, and thin-film inductors) to help improve signal integrity (e.g., in terms of signal-to-noise ratio, peak current, voltage droop, ground bounce or variations, etc.) of the signals and power communicated/provided to/from/between various devices of the IC device 100.

FIGS. 1-4 illustrate individual IC devices fabricated using layer transfer on a non-semiconductor support structure. In further embodiments, multiple such IC devices may be bonded together to form a microelectronic assembly. Still further, in some embodiments, such microelectronic assemblies may further include interconnects, such as conductive vias or conductive trenches, provided in one or both of the IC devices 100 after these IC devices have been bonded together. In the present disclosure, such interconnects are referred to as "after-bonding interconnects" and may include any combination of one or more after-bonding vias and/or after-bonding trenches. Providing one or more after-bonding interconnects may provide significant advantages in terms of its ability to provide electrical connectivity between various components of a microelectronic assembly and/or reduced resistance. Because of the reduced resistance, the after-bonding interconnects may be particularly suitable for routing power to various components of the microelectronic assembly 100, although they may also be used to route ground and/or signals to various components of the microelectronic assembly. Also because of the reduced resistance, the after-bonding interconnects may be referred to as "express interconnects" (e.g., an express via) because they may allow routing power, ground, and/or signals to various components of the microelectronic assembly faster than what would be achieved with the interconnects that were in the individual IC devices 100 before they were bonded together.

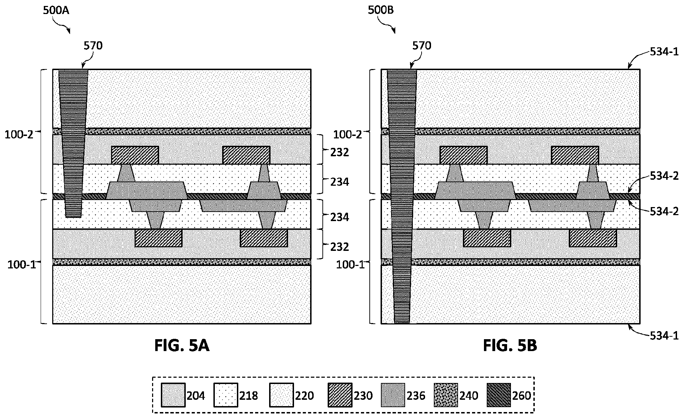

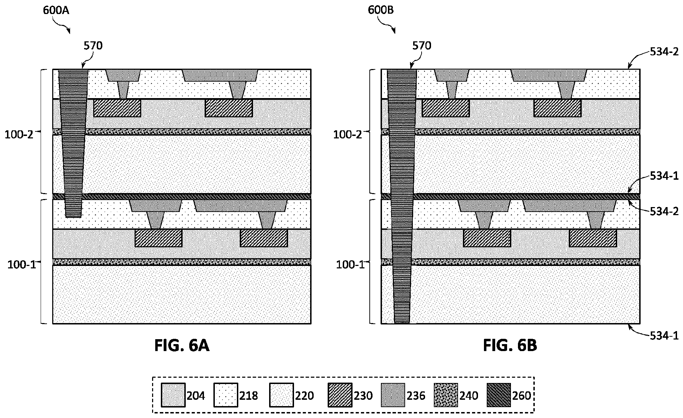

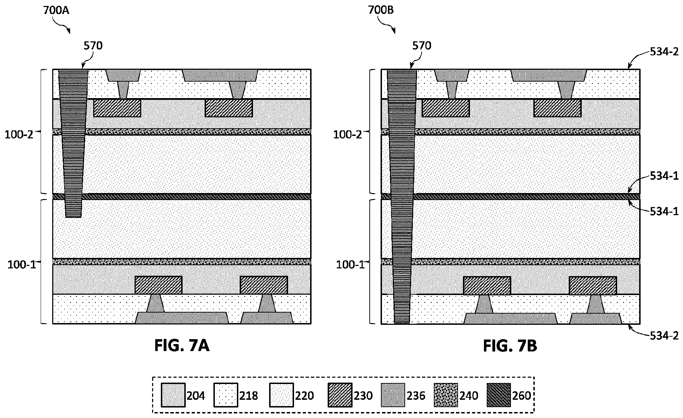

FIGS. 5-7 provide some examples of microelectronic assemblies that include two IC devices 100 as described herein bonded together. In particular, FIGS. 5A-5B provide schematic illustrations of cross-sectional side views of microelectronic assemblies 500 with a front-to-front (f2f) bonding of two IC devices 100, FIGS. 6A-6B provide schematic illustrations of cross-sectional side views of microelectronic assemblies 600 with a front-to-back (f2b) bonding of two IC devices 100, and FIGS. 7A-7B provide schematic illustrations of cross-sectional side views of microelectronic assemblies 700 with a back-to-back (b2b) bonding of two IC devices 100, according to various embodiments of the present disclosure. In each of FIGS. 5-7, the two IC devices bonded together are shown as an IC device 100-1 at the bottom of the illustrations and an IC device 100-2 at the top of the illustrations, where any of the IC devices 100-1 and 100-2 may take on any of the embodiments of the IC device 100, described herein. In order to not clutter the drawings, the transistors 230 of the IC devices 100-1 and 100-2 are shown in FIGS. 5-7 as boxes, and the device layer 232 and the backend layer 234 as described above are only labeled in FIG. 5A but not in other drawings of FIGS. 5-7 where they are illustrated in an analogous manner. Each of FIGS. 5-7 further illustrates a bonding interface 260 between the IC device 100-1 and the IC device 100-2, as well as an after-bonding via 570.

In general, bonding of the IC devices 100 to form the microelectronic assemblies as described herein may be performed as follows. First, the IC devices 100-1 and 100-2 may be fabricated individually, e.g., as described above. After that, one face of the IC device 100-1 and one face of the IC device 100-2 may be bonded. In some embodiments, bonding of the faces of the IC devices 100-1 and 100-2 may be performing using insulator-insulator bonding, e.g., as oxide-oxide bonding, where an insulating material 218 of the IC device 100-1 is bonded to an insulating material 218 of the IC device 100-2. In some embodiments, the bonding material 260 may be present in between at least portions of the faces of the IC devices 100-1 and 100-2 that are bonded together. To that end, the bonding material 260 may be applied to at least portions of the one or both faces of the IC devices 100-1 and 100-2 that should be bonded and then the IC devices 100-1 and 100-2 are put together, possibly while applying a suitable pressure and heating up the assembly to a suitable temperature (e.g., to moderately high temperatures, e.g., between about 50 and 200 degrees Celsius) for a duration of time. In some embodiments, the bonding material 260 may be an adhesive material that ensures attachment of the IC devices 100-1 and 100-2 to one another. In some embodiments, the bonding material 260 may be an etch-stop material. In some embodiments, the bonding material 260 may be both an etch-stop material and have suitable adhesive properties to ensure attachment of the IC devices 100-1 and 100-2 to one another. In some embodiments, no bonding material 260 may be used, in which case the layer labeled "260" in FIGs 5-7 represents a bonding interface resulting from the bonding of the IC devices 100-1 and 100-2 to one another. Such a bonding interface may be recognizable as a seam or a thin layer in the microelectronic assembly 100, using, e.g., SED, even when the specific materials of the insulators of the IC devices 100-1 and 100-2 that are bonded together may be the same, in which case the bonding interface would still be noticeable as a seam or a thin layer in what otherwise appears as a bulk insulator (e.g., bulk oxide) layer. As used herein, unless specified otherwise, references to the "bonding material 260" are applicable to a "bonding interface" for the embodiments where no deliberately added adhesive material is used to bond the IC devices 100-1 and 100-2.

Although not specifically shown in the present drawings, any embodiments of the microelectronic assemblies as described herein may further include one or more etch-stop materials that may be included in the IC device 100-1, e.g., between some or all pairs of metal layers of a metallization stack of the IC device 100-1, and/or in the IC device 100-2, e.g., between some or all pairs of metal layers of a metallization stack of the IC device 100-2. Such layers of etch-stop materials are commonly used in the field of semiconductor manufacturing, and may be provided at different locations of the IC devices 100-1, 100-2, the locations being dependent on, e.g., specific processing techniques used to manufacture portions of these IC structures. In some embodiments of bonding of the IC devices 100-1, 100-2, the material compositions of their etch-stop materials may be different. For example, the etch-stop material included in the IC device 100-1 may include a material with silicon and nitrogen (e.g., silicon nitride), while the etch-stop material included in the IC device 100-2 may include a material with silicon and carbon (e.g., silicon carbide), or one of the etch-stop materials included in the IC devices 100-1, 100-2 may include a material with aluminum and oxygen (e.g., aluminum oxide). Furthermore, the bonding material 260 at the interface between the IC devices 100-1 and 100-2 may have a material composition different from one or both of the etch-stop material included in the IC device 100-1 and the etch-stop material included in the IC device 100-2. For example, in some embodiments, the bonding material 260 may include silicon, nitrogen, and carbon, where the atomic percentage of any of these materials may be at least 1%, e.g., between about 1% and 50%, indicating that these elements are added deliberately, as opposed to being accidental impurities which are typically in concentration below about 0.1%. Having both nitrogen and carbon in these concentrations in addition to silicon is not typically used in conventional semiconductor manufacturing processes where, typically, either nitrogen or carbon is used in combination with silicon, and, therefore, would be a characteristic feature of the hybrid manufacturing as described herein. Using an etch-stop material at the interface between the IC devices 100-1 and 100-2 that includes include silicon, nitrogen, and carbon, where the atomic percentage of any of these materials may be at least 1%, e.g., SiOCN, may be advantageous in terms that such a material may act both as an etch-stop material, and have sufficient adhesive properties to bond the IC devices 100-1 and 100-2 together. In addition, an etch-stop material at the interface between the IC devices 100-1 and 100-2 that includes include silicon, nitrogen, and carbon, where the atomic percentage of any of these materials may be at least 1%, may be advantageous in terms of improving etch-selectivity of this material with respect to the etch-stop materials of the IC devices 100-1 and 100-2.

For each IC device 100, the terms "bottom face" or "backside" of the IC device may refer to the back of the IC device, e.g., bottom of the non-semiconductor support structure 220 of the IC device, while the terms "top face" or "frontside" of the structure may refer to the opposing other face. FIGS. 5B, 6B, and 7B indicate a backside 534-1 and a frontside 534-2 for each of the IC devices 100-1 and 100-2, while FIGS. 5A, 6A, and 7B have analogous orientation of the backsides and the frontsides of the IC devices 100 as, respectively, FIGS. 5B, 6B, and 7B, but those are not labeled in order to not clutter the drawings.

As can be seen in FIGS. 5A-5B, the microelectronic assembly 500 is an f2f-bonded assembly because the frontside 534-2 of the IC device 100-2 is bonded to the frontside 534-2 of the IC device 100-1. Thus, in an f2f-bonded assembly, one of the IC devices 100-1, 100-2 is flipped upside down for bonding so that the top face of the flipped IC device is facing and is bonded to the top face of the IC device that is not flipped. FIG. 5A illustrates that an after-bonding via 570 may extend from the backside 534-1 of the IC device 100-2 down towards the frontside 534-2 of the IC device 100-2, go through the bonding material 260, extend to the frontside 534-2 of the IC device 100-1 and into the IC device 100-1, but not reach the backside 534-1 of the IC device 100-1. The after-bonding via 570 as shown in FIG. 5A may allow providing power and/or signals to any of the components of the IC devices 100-1 and 100-2 from the backside 534-1 of the IC device 100-2. On the other hand, FIG. 5B illustrates an embodiment of the microelectronic assembly where the after-bonding via 570 is as shown in FIG. 5A except that it extends all the way down to the backside 534-1 of the IC device 100-1. The after-bonding via 570 as shown in FIG. 5B may allow routing power and/or signals between the backside 534-1 of the IC device 100-2 and the backside 534-1 of the IC device 100-1, and to any of the components of the IC devices 100-1 and 100-2, using the after-bonding via 570 that is a through-substrate via (TSV) extending through both of the IC devices 100-1 and 100-2.

As can be seen in FIGS. 6A-6B, the microelectronic assembly 600 is an f2b-bonded assembly because the backside 534-1 of the IC device 100-2 is bonded to the frontside 534-2 of the IC device 100-1. Thus, in an f2b-bonded assembly, the IC device 100-2 is not flipped upside down for bonding so that the bottom face of the IC device 100-2 is facing and is bonded to the top face of the IC device 100-1 that is also not flipped. FIG. 6A illustrates that an after-bonding via 570 may extend from the frontside 534-2 of the IC device 100-2 down towards the backside 534-1 of the IC device 100-2, go through the bonding material 260, extend to the frontside 534-2 of the IC device 100-1 and into the IC device 100-1, but not reach the backside 534-1 of the IC device 100-1. The after-bonding via 570 as shown in FIG. 6A may allow providing power and/or signals to any of the components of the IC devices 100-1 and 100-2 from the frontside 534-2 of the IC device 100-2. On the other hand, FIG. 6B illustrates an embodiment of the microelectronic assembly where the after-bonding via 570 is as shown in FIG. 6A except that it extends all the way down to the backside 534-1 of the IC device 100-1. The after-bonding via 570 as shown in FIG. 6B may allow routing power and/or signals between the frontside 534-2 of the IC device 100-2 and the backside 534-1 of the IC device 100-1, and to any of the components of the IC devices 100-1 and 100-2, using the after-bonding via 570 that is a TSV extending through both of the IC devices 100-1 and 100-2.

As can be seen in FIGS. 7A-7B, the microelectronic assembly 700 is a b2b-bonded assembly because the backside 534-1 of the IC device 100-2 is bonded to the backside 534-1 of the IC device 100-1. Thus, in a b2b-bonded assembly, the IC device 100-2 is not flipped upside down but the IC device 100-1 is flipped upside down for bonding so that the bottom face of the IC device 100-2 is facing and is bonded to the bottom face of the IC device 100-1. FIG. 7A illustrates that an after-bonding via 570 may extend from the frontside 534-2 of the IC device 100-2 down towards the backside 534-1 of the IC device 100-2, go through the bonding material 260, extend to the backside 534-1 of the IC device 100-1 and into the IC device 100-1, but not reach the frontside 534-2 of the IC device 100-1. The after-bonding via 570 as shown in FIG. 7A may allow providing power and/or signals to any of the components of the IC devices 100-1 and 100-2 from the frontside 534-2 of the IC device 100-2. On the other hand, FIG. 7B illustrates an embodiment of the microelectronic assembly where the after-bonding via 570 is as shown in FIG. 7A except that it extends all the way down to the frontside 534-2 of the IC device 100-1. The after-bonding via 570 as shown in FIG. 7B may allow routing power and/or signals between the frontside 534-2 of the IC device 100-2 and the frontside 534-2 of the IC device 100-1, and to any of the components of the IC devices 100-1 and 100-2, using the after-bonding via 570 that is a TSV extending through both of the IC devices 100-1 and 100-2.

### Example electronic devices

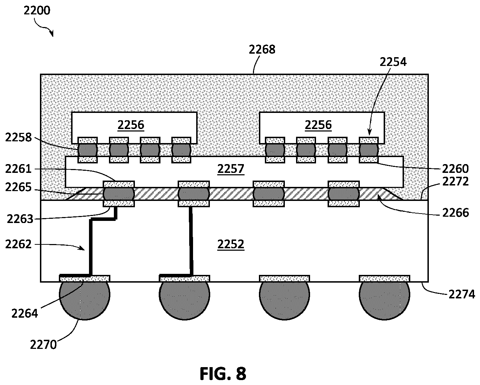

IC devices fabricated using layer transfer on a non-semiconductor support structure as disclosed herein may be included in any suitable electronic device. FIGS. 8-10 illustrate various examples of devices and components that may include one or more IC devices fabricated using layer transfer on a non-semiconductor support structure as disclosed herein.

FIG. 8 is a side, cross-sectional view of an example IC package 2200 that may include one or more IC devices fabricated using layer transfer on a non-semiconductor support structure in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

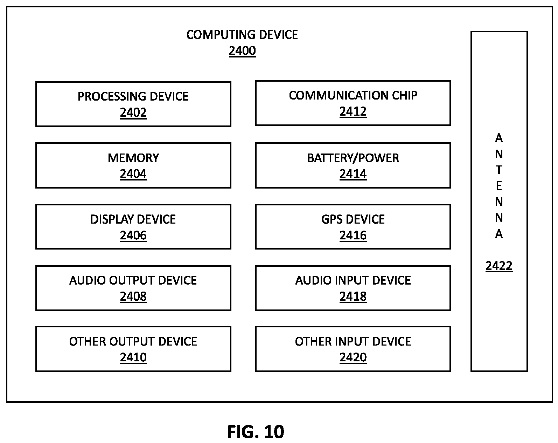

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 10 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 8 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

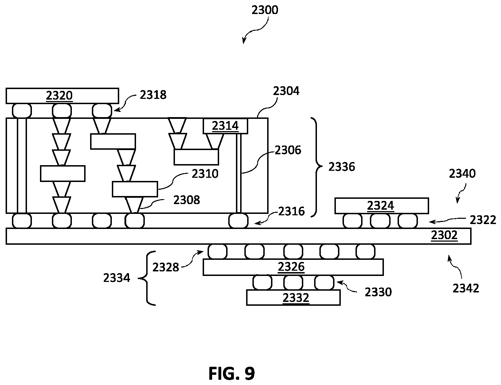

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 8 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 9.

The dies 2256 may take the form of any of the embodiments of the IC devices fabricated using layer transfer on a non-semiconductor support structure discussed herein. In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded logic and memory devices as described herein. In some embodiments, any of the dies 2256 may include one or more IC devices fabricated using layer transfer on a non-semiconductor support structure, e.g., as discussed above; in some embodiments, at least some of the dies 2256 may not include any of the IC devices fabricated using layer transfer on a non-semiconductor support structure.

The IC package 2200 illustrated in FIG. 8 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 8, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 9 is a cross-sectional side view of an IC device assembly 2300 that may include components having one or more IC devices fabricated using layer transfer on a non-semiconductor support structure in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC devices fabricated using layer transfer on a non-semiconductor support structure in accordance with any of the embodiments disclosed herein; e.g., any of the IC packages discussed below with reference to the IC device assembly 2300 may take the form of any of the embodiments of the IC package 2200 discussed above with reference to FIG. 8 (e.g., may include one or more IC devices fabricated using layer transfer on a non-semiconductor support structure provided on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 9 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 9), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 include one or more IC devices fabricated using layer transfer on a non-semiconductor support structure as described herein. Although a single IC package 2320 is shown in FIG. 9, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 9, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as radio frequency (RF) devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 9 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 10 is a block diagram of an example computing device 2400 that may include one or more components with one or more IC devices fabricated using layer transfer on a non-semiconductor support structure in accordance with any of the embodiments disclosed herein. Any of the components of the computing device 2400 may include an IC package 2200 as described with reference to FIG. 8. Any of the components of the computing device 2400 may include an IC device assembly 2300 as described with reference to FIG. 9.

A number of components are illustrated in FIG. 10 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 10, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402. This memory may be used as cache memory and may include one or more IC devices fabricated using layer transfer on a non-semiconductor support structure as described herein.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 602.11 family), IEEE 602.16 standards (e.g., IEEE 602.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 602.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 602.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

### Select examples

The following paragraphs provide various examples of the embodiments disclosed herein.

Example 1 provides an IC device that includes a support structure of a non-semiconductor material having a dielectric constant that is smaller than a dielectric constant of silicon (e.g., a glass wafer); a device layer, where a portion of the device layer includes a semiconductor material; and a bonding interface between the support structure and the device layer.

Example 2 provides the IC device according to example 1, further including a transistor, where a channel of the transistor includes at least a portion of the semiconductor material.

Example 3 provides the IC device according to examples 1 or 2, further including an interconnect layer, where the device layer is between the bonding interface and the interconnect layer.

Example 4 provides the IC device according to example 3, where the IC device includes a first IC assembly, a second IC assembly, and a further bonding interface between the first IC assembly and the second IC assembly; the device layer is a first device layer; the interconnect layer is a first interconnect layer; the first IC assembly includes the support structure, the first device layer, the first interconnect layer, and the bonding interface; and the second IC assembly includes a second device layer and a second interconnect layer.

Example 5 provides the IC device according to example 4, where the support structure is a first support structure; the non-semiconductor material is a first non-semiconductor material; the bonding interface is a first bonding interface; the second IC assembly further includes a second support structure of a second non-semiconductor material and a second bonding interface between the second support structure and the second device layer; the second device layer is between the second bonding interface and the second interconnect layer; and the further bonding interface is between the first bonding interface and the second bonding interface.

Example 6 provides the IC device according to example 5, where the first interconnect layer is closer to the further bonding interface than the first device layer, and the second interconnect layer is closer to the further bonding interface than the second device layer.

Example 7 provides the IC device according to example 5, where the first interconnect layer is closer to the further bonding interface than the first device layer, and the second device layer is closer to the further bonding interface than the second interconnect layer.

Example 8 provides the IC device according to example 5, where the first device layer is closer to the further bonding interface than the first interconnect layer, and the second interconnect layer is closer to the further bonding interface than the second device layer.

Example 9 provides the IC device according to example 5, where the first device layer is closer to the further bonding interface than the first interconnect layer, and the second device layer is closer to the further bonding interface than the second interconnect layer.

Example 10 provides the IC device according to example 9, where the further bonding interface bonds the second support structure and the first support structure.

Example 11 provides the IC device according to any one of examples 5-10, where each of the first IC assembly and the second IC assembly has a first face and a second face, the further bonding interface is between the first face of the first IC assembly and the first face of the second IC assembly, and the IC device further includes a conductive via extending from the second face of the second IC assembly to the first face of the second IC assembly, through the further bonding interface, and towards the second face of the first IC assembly.

Example 12 provides the IC device according to example 11, where the conductive via extends to the second face of the first IC assembly.

Example 13 provides the IC device according to any one of the preceding examples, where the semiconductor material is a crystalline semiconductor material.

Example 14 provides the IC device according to any one of the preceding examples, where the semiconductor material includes silicon.

Example 15 provides the IC device according to any one of the preceding examples, where the semiconductor material includes a III-N semiconductor material.

Example 16 provides the IC device according to any one of the preceding examples, where the bonding interface includes an oxide material.

Example 17 provides the IC device according to any one of the preceding examples, where the bonding interface includes one or more portions in contact with one or more portions of the support structure, and one or more portions in contact with one or more portions of the semiconductor material.

Example 18 provides an IC package that includes an IC device; and a further IC component, coupled to the IC device. In some embodiments of example 18, the IC device may be an IC device according to any one of the preceding examples. In other embodiments of example 18, the IC device may include a glass substrate, and a device layer, including a transistor provided over the glass substrate, where a channel region of the transistor includes a semiconductor material.

Example 19 provides the IC package according to example 18, where the further IC component includes one of a package substrate, an interposer, or a further IC die.

Example 20 provides the IC package according to examples 18 or 20, where the IC device includes, or is a part of, at least one of a memory device, a computing device, a wearable device, a handheld electronic device, and a wireless communications device.

Example 21 provides an electronic device that includes a carrier substrate; and one or more of the IC device according to any one of the preceding examples and the IC package according to any one of the preceding examples, coupled to the carrier substrate.

Example 22 provides the electronic device according to example 21, where the carrier substrate is a motherboard.

Example 23 provides the electronic device according to example 21, where the carrier substrate is a PCB.

Example 24 provides the electronic device according to any one of examples 21-23, where the electronic device is a wearable electronic device (e.g., a smart watch) or handheld electronic device (e.g., a mobile phone).

Example 25 provides the electronic device according to any one of examples 21-24, where the electronic device further includes one or more communication chips and an antenna.

Example 26 provides the electronic device according to any one of examples 21-25, where the electronic device is an RF transceiver.

Example 27 provides the electronic device according to any one of examples 21-25, where the electronic device is one of a switch, a power amplifier, a low-noise amplifier, a filter, a filter bank, a duplexer, an upconverter, or a downconverter of an RF communications device, e.g., of an RF transceiver.

Example 28 provides the electronic device according to any one of examples 21-25, where the electronic device is a computing device.

Example 29 provides the electronic device according to any one of examples 21-28, where the electronic device is included in a base station of a wireless communication system.

Example 30 provides the electronic device according to any one of examples 21-28, where the electronic device is included in a user equipment device (i.e., a mobile device) of a wireless communication system.

Example 31 provides a method of fabricating an IC device. The method includes fabricating a device layer over a semiconductor support structure, the device layer comprising a plurality of frontend devices; attaching the semiconductor support structure with the device layer to a carrier substrate so that the device layer is closer to the carrier substrate than the semiconductor support structure; removing at least a portion of the semiconductor support structure to expose the device layer; and bonding a support structure of a non-semiconductor material having a dielectric constant that is smaller than a dielectric constant of silicon (e.g., a glass wafer) to the exposed frontend layer.

Example 32 provides the method according to example 31, further comprising, prior to the attaching, fabricating a backend layer over the device layer, the backend layer comprising one or more interconnects and backend devices coupled to one or more of the plurality of frontend devices, wherein the attaching includes attaching the semiconductor support structure with the device layer and the backend layer to the carrier substrate so that the device layer is closer to the carrier substrate than the backend layer.

Example 33 provides the method according to examples 31 or 32, where bonding the support structure of the non-semiconductor material to the exposed device layer includes providing one or more bonding materials on at least one of the exposed device layer and a face of the support structure of the non-semiconductor material to be bonded to the exposed device layer, and attaching the exposed device layer to the face of the support structure of the non-semiconductor material to be bonded to the exposed device layer.

Example 34 provides the method according to any one of examples 31-33, where removing the at least portions of the semiconductor support structure includes polishing or grinding away the semiconductor support structure until the frontend layer is exposed.

Example 35 provides the method according to any one of examples 31-34, where the non-semiconductor support structure includes glass.

Example 36 provides the method according to any one of examples 31-35, where the non-semiconductor support structure includes mica.

Example 37 provides the method according to any one of examples 31-36, further including processes for forming the IC device according to any one of the preceding examples (e.g., for forming the IC device according to any one of examples 1-17).

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a support structure of a non-semiconductor material having a dielectric constant that is smaller than a dielectric constant of silicon;
a device layer, wherein a portion of the device layer includes a semiconductor material; and
a bonding interface between the support structure and the device layer.

2. The IC device according to claim 1, further comprising a transistor, where a channel of the transistor includes at least a portion of the semiconductor material.

3. The IC device according to any one of claims 1-2, further comprising an interconnect layer, where the device layer is between the bonding interface and the interconnect layer.

4. The IC device according to claim 3, wherein:
the IC device includes a first IC assembly, a second IC assembly, and a further bonding interface between the first IC assembly and the second IC assembly,
the device layer is a first device layer,
the interconnect layer is a first interconnect layer,
the first IC assembly includes the support structure, the first device layer, the first interconnect layer, and the bonding interface, and
the second IC assembly includes a second device layer and a second interconnect layer.

5. The IC device according to claim 4, wherein:
the support structure is a first support structure,
the non-semiconductor material is a first non-semiconductor material,
the bonding interface is a first bonding interface,
the second IC assembly further includes a second support structure of a second non-semiconductor material and a second bonding interface between the second support structure and the second device layer,
the second device layer is between the second bonding interface and the second interconnect layer, and
the further bonding interface is between the first bonding interface and the second bonding interface.

6. The IC device according to claim 5, wherein:
the first interconnect layer is closer to the further bonding interface than the first device layer, and
the second interconnect layer is closer to the further bonding interface than the second device layer.

7. The IC device according to claim 5 or 6, wherein:
the first interconnect layer is closer to the further bonding interface than the first device layer, and
the second device layer is closer to the further bonding interface than the second interconnect layer.

8. The IC device according to claim 5, 6 or 7, wherein:
the first device layer is closer to the further bonding interface than the first interconnect layer, and
the second interconnect layer is closer to the further bonding interface than the second device layer.

9. The IC device according to claim 5, 6, 7 or 8, wherein:
the first device layer is closer to the further bonding interface than the first interconnect layer, and
the second device layer is closer to the further bonding interface than the second interconnect layer.

10. The IC device according to claim 9, wherein the further bonding interface bonds the second support structure and the first support structure.

11. The IC device according to any one of claims 5-10, wherein:
each of the first IC assembly and the second IC assembly has a first face and a second face,
the further bonding interface is between the first face of the first IC assembly and the first face of the second IC assembly, and
the IC device further includes a conductive via extending from the second face of the second IC assembly to the first face of the second IC assembly, through the further bonding interface, and towards the second face of the first IC assembly.

12. The IC device according to claim 11, wherein the conductive via extends to the second face of the first IC assembly.

13. The IC device according to any one of claims 1-12, wherein the semiconductor material includes one or more of silicon and a III-N semiconductor material.

14. A method of fabricating an integrated circuit (IC) device, the method comprising:
fabricating a device layer over a semiconductor support structure, the device layer comprising a plurality of frontend devices;
attaching the semiconductor support structure with the device layer to a carrier substrate so that the device layer is closer to the carrier substrate than the semiconductor support structure;
removing at least a portion of the semiconductor support structure to expose the device layer; and
bonding a support structure of a non-semiconductor material having a dielectric constant that is smaller than a dielectric constant of silicon to the exposed frontend layer.

15. The method according to claim 14, further comprising:
prior to the attaching, fabricating a backend layer over the device layer, the backend layer comprising one or more interconnects and backend devices coupled to one or more of the plurality of frontend devices,
wherein the attaching includes attaching the semiconductor support structure with the device layer and the backend layer to the carrier substrate so that the device layer is closer to the carrier substrate than the backend layer.
